# DEMANDE DE BREVET EUROPEEN

(11) **EP 4 730 048 A1**
(43) Date de publication de la demande: **22.04.2026**
(21) Numéro de dépôt: 24207485.4
(22) Date de dépôt: 18.10.2024
(51) Int. Cl.: G04B 13/02, G04B 15/14, G04B 17/06, G04D 3/00, B81C 99/00

(54) **PROCÉDÉ DE FABRICATION DE COMPOSANTS HORLOGERS EN SILICIUM SUR UNE PLAQUETTE SIMPLE EN SILICIUM SANS COUCHE DE SUPPORT.**

(71) Demandeur: Richemont International S.A., 1752 Villars-sur-Glâne (CH)
(72) Inventeur: CHABART, Mickaël, 2014 Fleurier (CH); DEMOLON, Pierre, 2023 Gorgier (CH)
(74) Mandataire: Novagraaf International SA

(57) **Abrégé**

Un procédé de fabrication d'une pluralité de composants horlogers (90) dans une plaquette (110) comprend les étapes de : (a) se doter d'une plaquette (110) ayant un côté inférieur (110A) et un côté supérieur (110B), la plaquette (110) comprenant une couche simple en silicium (130) sans couche de support, la couche simple (130) ayant une épaisseur (e130) plus importante qu'une épaisseur maximale (e90) des composants ; (b) former les composants (90) en gravant des motifs dans la couche simple en silicium (130) depuis le côté supérieur (110B) de la plaquette (110) afin d'obtenir une couche simple structurée (130'), la couche simple structurée (130') comprenant des régions (135) autour des motifs gravés dans lesquelles le matériau de la couche simple a été éliminé, et les régions éliminées (135) ayant une profondeur (p) correspondant sensiblement à l'épaisseur maximale (e90) des composants ; (c) former une couche de protection (155, 260) au moins sur les surfaces des flancs des composants gravés à l'étape (b); et (d) effectuer une gravure du silicium dans la couche simple structurée (130') à travers les régions éliminées (135) de ladite couche afin d'obtenir une couche simple structurée et excavée (130") ayant au moins une cavité (124) formée en dessous d'au moins un composant (90).

## Description

### Domaine technique

L'invention concerne un procédé de fabrication de composants horlogers en silicium sur une plaquette simple en silicium sans couche de support. Le procédé de fabrication comprend généralement des étapes de microfabrication incluant la lithographie et la gravure de la couche de silicium de la plaquette ainsi que des étapes de fabrication postérieures à la gravure incluant la libération des composants.

### Etat de la technique

La fabrication de composants horlogers en silicium tels que, mais de façon non limitative, des ressorts spiraux, des cames, des ressorts, des cliquets, des roues et des ancres en utilisant des procédés de microfabrication est bien connue. Avantageusement, plusieurs centaines de composants horlogers peuvent être fabriqués sur une seule plaquette (en anglais « wafer ») en utilisant ces technologies. Il est, par exemple, connu de réaliser une pluralité de résonateurs en silicium avec une très haute précision en utilisant des procédés de photolithographie et d'usinage par gravure dans une plaquette en silicium. Les procédés de réalisation de ces composants horlogers utilisent généralement des plaquettes de silicium monocristallin, mais des plaquettes en silicium polycristallin ou amorphe sont également utilisables.

Le silicium est un matériau diamagnétique, et son utilisation pour la fabrication de composants horlogers, et notamment pour les composants de l'organe régulateur d'un mouvement de montre mécanique, est avantageuse car aucun effet rémanent n'est observé après l'exposition de ce matériau aux champs magnétiques. De plus, les variations du module d'Young d'un composant horloger en silicium en fonction de la température peuvent être compensées par l'ajout d'une couche d'oxyde SiO₂ sur le composant. Quand les composants horlogers sont réalisés à partir d'une plaquette en silicium monocristallin, l'une quelconque des trois orientations cristallines <100>, <110> ou <111> peut être utilisée.

Les plaquettes de silicium sont proposées sous forme de galette simple, par exemple des wafers de type SSP (« Single Side polished » en anglais) ou de type DSP (« Dual Side Polished » en anglais). Le document EP3495894 décrit un procédé de fabrication de composants horlogers en silicium utilisant une telle plaquette comprenant une couche simple en silicium sans couche de support. Selon ce document, la plaquette simple a une épaisseur sensiblement égale à l'épaisseur maximale des composants horlogers à fabriquer, et pour former les composants horlogers, on effectue une étape de gravure dans toute l'épaisseur de la plaquette, la totalité du matériau du composant présent dans la plaquette étant ainsi utilisée pour former les composants horlogers, sans fonction de support dans la plaquette. Après leur formation, les composants horlogers ne sont supportés structurellement que par des ponts de liaison fins qui les maintiennent attachés aux parties subsistantes de la couche simple en silicium, et il est possible d'effectuer des étapes de fabrication subséquentes sur la quasi-totalité de la surface externe des composants sans qu'il soit nécessaire d'effectuer une étape de libération des composants auparavant. Cependant, dans le procédé de fabrication du document EP3495894, l'étape de gravure est délicate car elle a lieu dans une plaquette relativement mince, et donc fragile, sans aucun support.

Alternativement, les plaquettes SOI (« silicon-on-insulator » en anglais) sont souvent utilisées pour la fabrication de composants horlogers. Une plaquette SOI comprend une couche de travail en silicium (la couche « device » en anglais) dans laquelle les composants horlogers sont fabriqués, une couche de support en silicium qui sert de substrat ou de support lors de la fabrication des composants (la couche « handle » en anglais), et une couche d'oxyde enterrée en SiO₂ qui se trouve entre les deux couches de silicium (la couche « buried oxide layer » ou BOX en anglais). La surface de la couche de travail et éventuellement la surface de la couche de support peuvent également être polies pour faciliter des étapes de lithographie sur ces couches.

Après les étapes de lithographie et de gravure pour initialement former les composants horlogers dans la couche de travail d'une plaquette SOI, les composants sont normalement libérés de la couche de support et de la couche d'oxyde enterrée de la plaquette SOI afin de faciliter des étapes de fabrication subséquentes. De cette manière, après la libération, les composants horlogers ne sont supportés structurellement que par des ponts de liaison fins qui les maintiennent attachés aux parties subsistantes de la couche de travail, ce qui permet notamment d'effectuer les étapes de fabrication subséquentes sur l'ensemble de la surface externe des composants de la plaquette. Les étapes subséquentes peuvent notamment comprendre des étapes d'oxydation et désoxydation pour le lissage des surfaces des composants. Les étapes subséquentes peuvent également comprendre des étapes d'oxydation et désoxydation pour ajuster les dimensions des composants (par exemple afin de corriger la raideur quand les composants sont des spiraux ou des résonateurs) et/ou des étapes d'oxydation pour former une couche externe d'oxyde de silicium sur les composants aux fins d'une compensation thermique et/ou d'un renforcement mécanique. Après ces étapes subséquentes, les composants horlogers peuvent être détachés de la plaquette et montés dans par exemple le mouvement d'une pièce d'horlogerie.

La libération des composants horlogers sur une plaquette SOI peut être réalisée par différentes méthodes. Une approche de libération est décrite dans les documents de brevet JP2017219520 et WO2019180177. Selon cette approche, après la formation des composants par gravure, on fait croître une couche d'oxyde de silicium en surface du silicium. Cette couche d'oxyde sert de protection pour les composants formés. Par la suite, on réalise une photolithographie et une gravure pour exposer le silicium de la couche de support et graver la couche de support en l'attaquant par la face opposée aux composants, ce qui enlève la couche de support en dessous des composants. Pour terminer la libération selon cette alternative, on élimine la couche enterrée du wafer SOI en dessous des composants ainsi que la couche de protection sur les composants. Cette approche de libération est relativement longue et coûteuse, car elle exige une structuration (voire des étapes de photolithographie et de gravure) au travers de la couche de support épaisse de la plaquette SOI.

Selon une autre approche décrite dans le document WO2019180596, après la formation des composants, la couche de travail (ou une partie de cette couche comprenant les composants) est séparée de la couche de support. Cette séparation peut être facilitée par la gravure d'une saignée entourant les composants ainsi que des ouvertures dans la couche de travail. Par la suite, la couche d'oxyde enterrée est gravée avec de la vapeur d'acide hydrofluorique (HF) qui passe au travers des ouvertures dans la couche de travail, et la partie de la couche de travail définie par la saignée est séparée de la couche de support de la plaquette SOI. Dans cette approche de libération, puisque la couche de travail est beaucoup plus fine et fragile que la couche de support, la réalisation d'étapes de fabrication subséquentes est plus délicate et risquée car elles sont effectuées sans le bénéfice de la couche de support, même pour le cas où elle est partiellement éliminée.

Les plaquettes SOI sont considérablement plus chères que des plaquettes de silicium simple. De plus les approches de libération des composants horlogers dans une plaquette SOI de l'art antérieur impliquent des étapes de microfabrication supplémentaires qui sont relativement longues, complexes et chères.

Il serait alors avantageux d'avoir un procédé de fabrication de composants horlogers en silicium plus économique et comprenant des étapes de libération des composants qui sont moins longues, plus efficaces et qui permettent de garder le bénéfice d'un support structurel pour des étapes de fabrication subséquentes qui ont lieu sur les composants après leur libération.

### Bref résumé de l'invention

Un but de la présente invention est de proposer un procédé de fabrication d'une pluralité de composants horlogers sur une plaquette comprenant une couche simple en silicium sans couche de support, qui permet d'éviter ou de pallier les inconvénients ci-dessus, ou en tout cas d'offrir un meilleur compromis entre ces inconvénients.

En particulier, ce but est au moins partiellement atteint en proposant un nouveau procédé de fabrication de composants horlogers en silicium selon lequel les composants sont initialement formés dans plaquette consistant en une couche simple en silicium qui est plus épaisse que l'épaisseur maximale des composants horlogers. L'utilisation d'une plaquette comprenant une seule couche en silicium sans couche de support est plus simple et plus économique que l'utilisation d'une plaquette SOI multicouche. En même temps, la plaquette selon l'invention a toujours une rigidité plus importante qu'une plaquette comprenant une couche simple fine ayant la même épaisseur que l'épaisseur maximale des composants horlogers. Le procédé de fabrication selon l'invention permet également de libérer les composants horlogers sans avoir recours à une gravure longue et couteuse d'une couche de support tout en gardant le bénéfice d'un support structurel dans la plaquette durant des étapes de fabrication subséquentes effectuées sur les composants horlogers après leur libération

Ainsi, selon un aspect, la présente invention concerne un procédé de fabrication dans une plaquette, d'une pluralité de composants horlogers, ces composants horlogers présentant des flancs ayant des surfaces, le procédé comprenant les étapes suivantes : (a) se doter d'une plaquette ayant un côté inférieur et un côté supérieur, la plaquette comprenant une couche simple en silicium sans couche de support, la couche simple ayant une épaisseur plus importante qu'une épaisseur maximale des composants horlogers ; (b) former les composants horlogers (avec leurs flancs), ou du moins une ébauche des composants horlogers, en gravant des motifs dans la couche simple en silicium depuis le côté supérieur de la plaquette afin d'obtenir une couche simple structurée, la couche simple structurée comprenant des régions éliminées autour des motifs gravés dans lesquelles le matériau de la couche simple a été éliminé, et les régions éliminées ayant une profondeur correspondant sensiblement à l'épaisseur maximale des composants horlogers ; (c) former une couche de protection au moins sur les surfaces des flancs des composants horlogers gravés à l'étape (b); et (d) effectuer une gravure du silicium dans la couche simple structurée depuis ou à travers les régions éliminées de ladite couche afin d'obtenir une couche simple structurée et excavée ayant au moins une cavité formée en dessous d'au moins un composant horloger. Contrairement à une plaquette SOI, la plaquette est exempte de couche support et de couche enterrée en oxyde de silicium, et de préférence la plaquette consiste en une seule couche simple de silicium.

D'autres caractéristiques avantageuses et privilégiées du procédé de fabrication sont précisées dans la description et les sous-revendications ci-dessous.

### Brève description des figures

Des exemples de mise en oeuvre de l'invention sont indiqués dans la description illustrée par les figures annexées dans lesquelles :
- Les figures 1a-1m illustrent schématiquement une série d'étapes de fabrication d'un composant horloger en silicium dans une plaquette comprenant une couche simple en silicium selon un mode de réalisation ;
- Les figures 2 et 2A sont des vues de dessus de la couche en silicium après les étapes de la figure 1 selon un mode de réalisation ;
- La figure 3 est une vue en section selon la ligne III-III de la figure 2 ; et
- Les figures 4a-4o illustrent schématiquement une série d'étapes de fabrication d'un composant horloger en silicium dans une plaquette comprenant une couche simple en silicium selon un autre mode de réalisation.

### Exemples de mode de réalisation de l'invention

Dans tout ce qui suit, les orientations sont les orientations des figures. En particulier, les termes comme « supérieur », « inférieur », « gauche », « droit », « dessus », « dessous », « horizontal », « vertical », « vers l'avant » et « vers l'arrière » s'entendent généralement par rapport au sens de représentation des figures. Les figures sont schématiques et peuvent présenter des proportions et/ou des aspects différents de la réalité même au sein d'une même figure, mais illustrent à tout le moins le déroulement et/ou les étapes des procédés décrits.

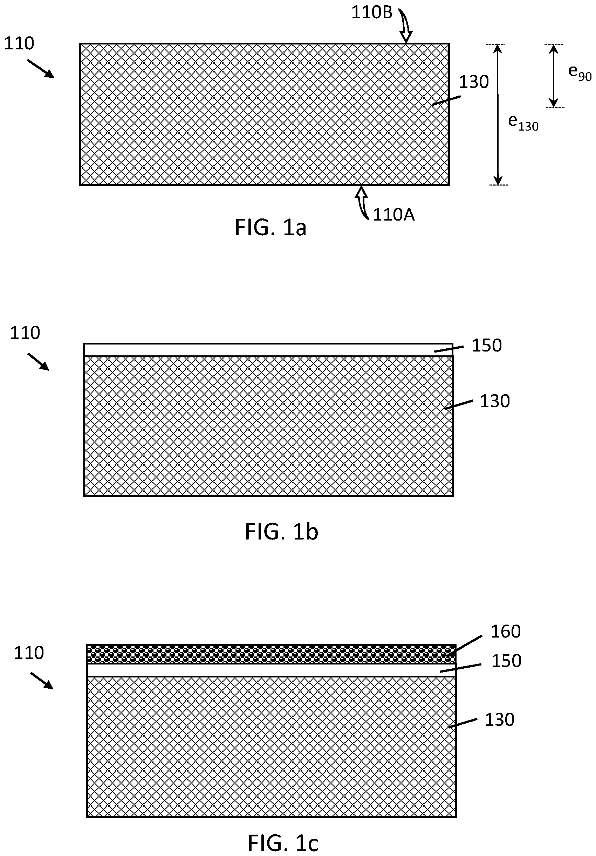

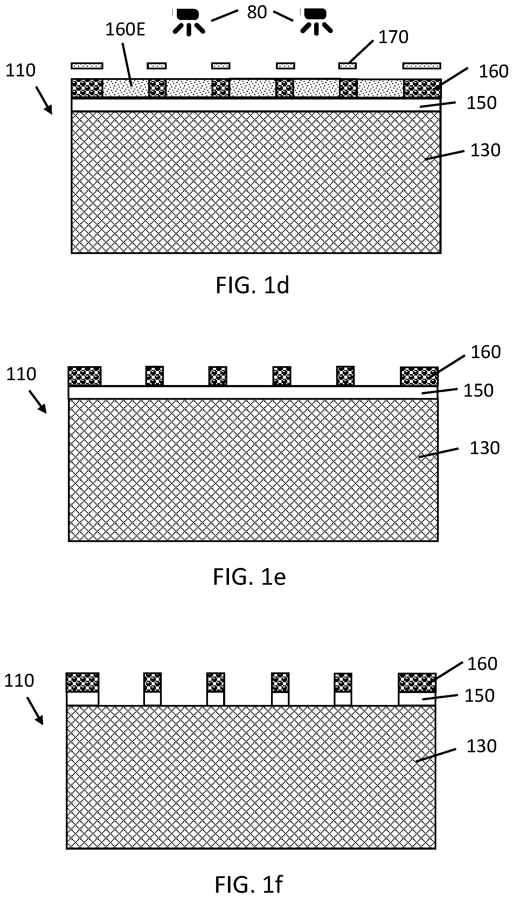

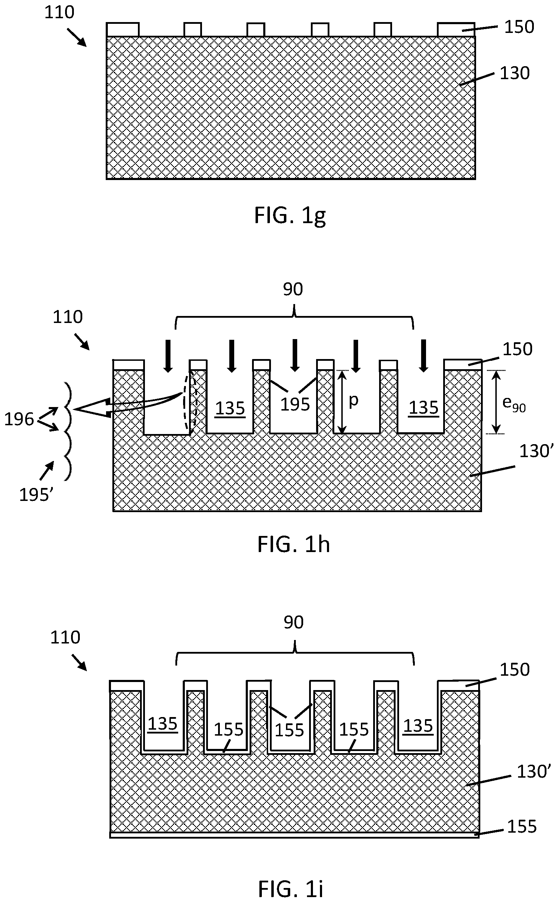

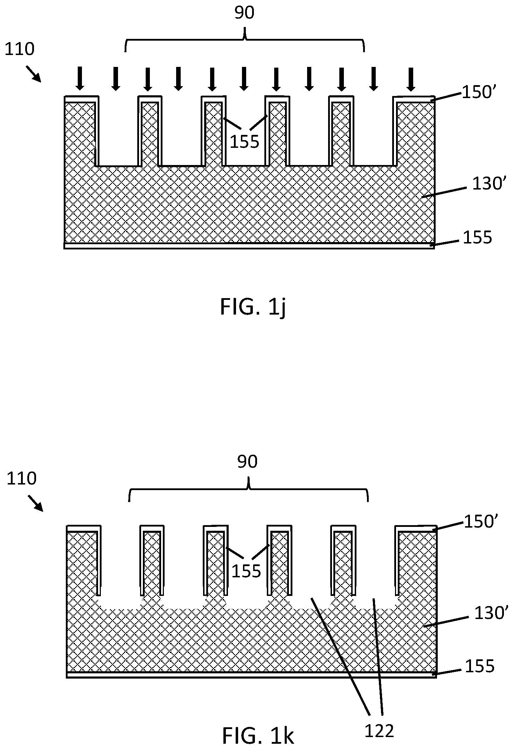

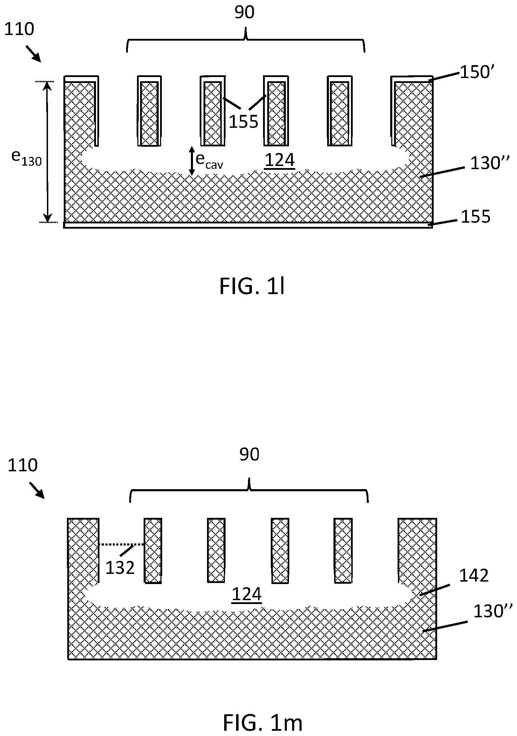

Les figures 1a-1m illustrent une série d'étapes de fabrication schématiques d'un composant horloger dans une plaquette simple 110 selon un mode de réalisation de l'invention. Plusieurs composants horlogers peuvent être fabriqués dans la plaquette 110 en même temps, mais les vues de la figure 1 sont isolées sur un seul composant pour des raisons de simplicité. Le procédé commence avec la plaquette simple 110 illustrée à la figure 1a, cette plaquette comprenant une couche simple 130 en silicium sans couche de support. La couche simple 130 (voire la plaquette 110) a une épaisseur initiale e₁₃₀ qui est plus importante que l'épaisseur maximale e₉₀ des composants horlogers à former. Le dessin n'est pas à l'échelle, mais à titre d'exemple, la couche simple 130 peut avoir une épaisseur initiale e₁₃₀ de 150 µm - 500 µm, et de préférence de 200 µm - 300 µm. Dans un exemple, la couche simple 130 a une épaisseur e₁₃₀ de 250 µm. Pour sa part, l'épaisseur maximale e₉₀ des composants horlogers peut varier, mais dans un exemple elle est égale à 120 µm. En général, on peut avoir une tolérance d'au moins ± 5-10 µm autour de cette épaisseur ciblée e₉₀ pour les composants horlogers, car leur épaisseur finale ne constitue pas typiquement une caractéristique critique dans leur performance. La couche simple 130 peut être en silicium monocristallin avec une orientation cristalline quelconque, en silicium polycristallin, ou en silicium amorphe, et elle peut être dopée type N ou type P. L'utilisation d'un silicium fortement dopé peut être avantageuse pour la fabrication des résonateurs car, par exemple, on constate une déformation moindre de la matière dopée lors de l'oxydation thermique sous certaines conditions. La plaquette 110 comprend un côté inférieur 110A, et c'est depuis ce côté que la plaquette 110 repose normalement sur des équipements lors des étapes de microfabrication pour former les composants horlogers. La plaquette 110 comprend également un côté supérieur 110B, et c'est depuis ce côté que ces étapes de microfabrication pour former les composants horlogers sont généralement effectuées.

Lors des différentes étapes de fabrication décrites ci-dessous (incluant la lithographie et la gravure), la couche simple 130 peut être montée sur un support plan (non illustré), mais cela n'est pas indispensable puisque la couche simple 130 a quand même une épaisseur e₁₃₀ qui est plus importante que l'épaisseur maximale e₉₀ des composants horlogers à former. Cependant, si c'est utile, un tel support peut être par exemple en métal, en céramique, en verre, en quartz ou en silicium et de préférence le support est plus épais et/ou plus rigide que la couche simple 130 afin qu'il soit plus facile de le manipuler. Par ailleurs, pour au moins certaines des étapes, la couche simple peut également être liée temporairement à un tel support par des moyens adhésifs (par exemple de la colle ou un ruban adhésif (par exemple, de type Kapton^{®}) appliqué à la périphérie de la couche) ou un système d'aspiration sous vide.

Dans la figure 1b, une étape de lithographie commence avec la formation d'une couche d'oxyde de silicium 150 sur la surface supérieure de la couche simple 130. La couche d'oxyde 150 peut par exemple avoir une épaisseur allant jusqu'à 6 µm, et elle peut être formée par oxydation thermique ou alternativement par un dépôt de type PVD, CVD, ou ALD. Si la couche d'oxyde 150 est formée par un procédé de dépôt directionnel tel que le CVD ou le PVD, l'oxyde se forme uniquement sur la surface supérieure de la couche simple 130, tel qu'illustré à la figure 1b. Alternativement, si la couche d'oxyde 150 est formée par oxydation thermique, on remarque que l'oxyde 150 se forme généralement en même temps sur la surface inférieure de la couche simple 130 (voire depuis son côté inférieur 110A) ou encore un second dépôt directionnel de type CVD ou PVD peut être effectué sur cette surface. De manière générale, la formation de la couche d'oxyde 150 avant le dépôt d'une couche de résine (voir la figure 1c) permet de déposer une couche de résine relativement fine et uniforme avec une bonne homogénéité de surface et ainsi d'optimiser la gravure subséquente de motifs fins et profonds dans la couche simple 130. Cependant, dans d'autres modes de réalisation, il est également possible de réaliser une étape de lithographie sans la couche d'oxyde 150, notamment en utilisant une résine photosensible plus épaisse.

A la figure 1c, la couche d'oxyde 150 est recouverte d'une couche de résine 160, qui est typiquement une résine photosensible de type positif ou négatif. Cette couche de résine peut avoir une épaisseur comprise entre 0.5 - 12 µm, à titre purement illustratif. Par la suite, dans la figure 1d, la couche de résine 160 est structurée de préférence en utilisant une étape de photolithographie avec une source de lumière ultraviolette 80 ainsi que, par exemple, un masque d'exposition 170 tel qu'un photomasque. Un système de stepper et réticule peut également être utilisé pour l'étape de photolithographie, ou alors un système d'écriture directe (i.e. sans photomasque) tel qu'un système de lithographie par laser ou un faisceau d'électrons (la lithographie e-beam). Dans l'exemple illustré, la couche 160 comprend une résine photosensible de type positif dont les parties 160E de la résine qui sont exposées à la lumière deviennent solubles dans un révélateur et les parties non exposées restent insolubles.

Dans la figure 1e, la couche de résine 160 est ouverte après avoir été développée par un révélateur, notamment un solvant qui élimine les parties exposées 160E de la résine par voie chimique. Ensuite, à la figure 1f, les parties de la couche d'oxyde 150 qui se trouvaient en dessous des parties exposées 160E de la résine sont aussi retirées de la surface de la couche simple 130, et la couche d'oxyde 150 est donc structurée sur la surface de cette couche. Cette étape peut être réalisée par exemple en employant une gravure plasma sélective directionnelle utilisant un ou plusieurs gaz fluorés (tels que CHF3, C4F8, et/ou SF6) en combinaison avec au moins un des gaz He et/ou H2 en fonction des sélectivités et des vitesses de gravure souhaitées. L'utilisation d'une technique de gravure directionnelle est généralement privilégiée lors de cette étape car elle est plus précise, mais alternativement une gravure à base de vapeur d'acide hydrofluorique (HF) ou à base d'une solution liquide tampon de type BHF peut aussi être utilisée.

A l'étape illustrée à la figure 1g, la partie restante de la couche de résine 160 peut être éliminée, par exemple en utilisant un plasma dioxygène (O2), mais optionnellement on peut garder la partie restante de cette couche comme masque en plus de la couche d'oxide 150. Les étapes des figures 1a - 1g servent alors à former une couche en oxyde de silicium structurée 150 sur la surface supérieure de la couche simple 130. Selon des variantes, la couche en oxyde de silicium structurée peut être formée autrement.

Ensuite, à l'étape de la figure 1h, des motifs séparés par des régions (ou tranchées) 135 sont gravés dans la couche simple 130 au travers de la couche 150 structurée, et optionnellement la couche de résine restante 160, pour former le composant horloger 90 (ou du moins une ébauche du composant) dans une couche simple structurée 130'. Les motifs gravés ne s'étendent pas sur toute l'épaisseur e₁₃₀ de la couche simple structurée 130', et comme illustré la profondeur des régions 135 formées dans la couche simple structurée 130' correspond sensiblement à l'épaisseur maximale e₉₀ des composants horlogers. Cette profondeur peut varier légèrement entre ces régions à travers la plaquette 110 puisqu'elle ne comprend pas de couche d'arrêt pour arrêter la gravure uniformément.

La gravure à l'étape de la figure 1h peut notamment être effectuée par une technique de gravure ionique réactive profonde (également connue sous l'acronyme DRIE pour « Deep Reactive Ion Etching » en anglais), par exemple en utilisant le SF₆ comme gaz réactif pour graver le silicium de la couche simple 130 et en utilisant le gaz C₄F₈ périodiquement comme gaz de passivation pour la protection des surfaces des flancs latéraux 195 du composant horloger. La gravure DRIE permet de former des trous et des tranchées profondes dans la couche 130 avec un rapport largeur/hauteur important, ce qui est bien adapté pour des composants micromécaniques comme des composants horlogers. De manière connue, l'utilisation du gaz C₄F₈ comme gaz de passivation produit une couche de fluoropolymère sur les surfaces des flancs latéraux 195. Une telle couche, qui a typiquement une épaisseur de 0.1-5 µm, peut être enlevée des flancs par une technique appropriée par exemple en utilisant un plasma dioxygène (O₂).

Alternativement, la structuration de la couche simple peut être réalisée par d'autres technologies de gravure telles qu'une opération de gravure humide/chimique anisotrope, par exemple en utilisant un bain d'hydroxyde de potassium (KOH) ou d'hydroxyde de tétraméthylammonium (TMAH). Cependant, la résolution dimensionnelle des structures gravées est généralement moins bonne avec une structuration par gravure humide/chimique qu'avec une gravure ionique réactive profonde. Si une opération de gravure humide/chimique anisotrope est employée, la couche d'oxyde 150 n'est normalement pas formée sur la surface supérieure de la couche simple 130 avant le dépôt de la résine 160 sur cette surface.

Comme indiqué ci-dessus, il est également possible pour la partie restante de la couche de résine 160 d'être toujours présente lors de l'étape de gravure profonde (DRIE ou autre) de la couche simple 130. Cette partie restante de la couche de résine peut être retirée après la gravure, et dans ce cas, la couche simple 130 est gravée au travers des deux couches 150, 160 structurées (ou seulement à travers la couche 160 structurée si une couche oxyde 150 n'est pas présente). A titre d'exemple, une résine positive peut être retirée par des solvants de type acétone ou diméthylsulfoxyde (DMSO) ou avec un plasma O₂ soit avant soit après l'étape de gravure. Pour une résine négative comme le SU-8, un plasma CF4/O2 peut être employé pour son retrait.

Les figures 1i-1m illustrent l'approche de libération des composants horlogers 90 selon ce mode de réalisation de l'invention. A la figure 1i, une couche d'oxyde 155 de silicium (SiO₂) est de préférence formée sur l'ensemble des surfaces exposées de la plaquette 110, incluant les surfaces des flancs 195 du composant horloger. La couche d'oxyde 155 est de préférence formée par oxydation thermique et donc se forme également sur tout le silicium exposé de la plaquette simple 110 incluant notamment sur le fond des régions gravées 135 et sur la surface inferieure de la couche simple structurée 130' depuis le côté 110A de la plaquette, comme illustré. La couche d'oxyde 155 sur les surfaces des flancs 195 rejoint la couche d'oxyde 150 déjà présente sur la surface supérieure de la couche simple structurée 130' (voire la surface supérieure du composant horloger 90), et cette dernière couche peut devenir légèrement plus épaisse durant l'oxydation thermique. L'épaisseur de cette couche d'oxyde 155 peut varier mais de préférence elle est d'au moins 0.05 µm et reste inférieure à l'épaisseur de la couche d'oxyde 150 sur la surface supérieure de la couche simple structurée 130'.

La formation de la couche d'oxyde 155 sert notamment à protéger les flancs 195 des composants horlogers 90 ainsi que d'autres endroits de la plaquette où le silicium est exposé lors des étapes de fabrication suivantes du procédé. Alternativement, une couche de protection en oxyde de silicium (SiO₂) ou en un autre matériau (par exemple une résine, un polymère. ou un autre oxyde comme l'Al₂O₃) peut être sélectivement formée sur ces surfaces et notamment sur les surfaces des flancs 195. Un tel dépôt sélectif peut être réalisé à titre d'exemple par une technique à base de l'ALD (en anglais « atomic layer deposition ») tel que décrit dans le document Taguhi Yeghoyan, Vincent Pesce, Moustapha Jaffal, Gauthier Lefevre, Rémy Gassilloud, Nicolas Posseme, Marceline Bonvalot, Christophe Vallée; Low température Topographically Selective Déposition by Plasma Enhanced Atomic Layer Deposition with ion bombardment assistance. J. Vac. Sci. Technol. A 1 May 2021; 39 (3): 032416 ou le document A. Chaker, C. Vallee, V. Pesce, S. Belahcen, R. Vallat, R. Gassilloud, N. Posseme, M. Bonvalot, A. Bsiesy; Topographically selective déposition. Appl. Phys. Lett. 28 January 2019; 114 (4): 043101. D'autres techniques de dépôt sélectifs pourraient également être employées. Dans ce cas, de préférence le dépôt sélectif ne couvre les régions exposées de la couche simple structurée 130' en dessous des régions éliminées 135, ce qui permet d'omettre une étape de gravure directionnelle de la figure 1j et de procéder directement à l'étape de gravure de la figure 1k.

Comme décrit ci-dessus, si une gravure DRIE utilisant un gaz fluoré tel que le C₄F₈ a été employée à l'étape de la figure 1h, une couche de fluoropolymère se forme généralement sur les surfaces des flancs latéraux 195. Selon une variante, on peut garder et ne pas enlever cette couche fluoropolymère après la gravure DRIE de cette étape de la figure 1h, et cette couche fluoropolymère peut par la suite servir comme une couche de protection de ces flancs pour les étapes qui suivent. Une telle couche de protection peut avantageusement être utilisée, par exemple, quand une gravure ultérieure de la pour former une cavité dans la couche simple en dessous des composants horlogers (telle que décrite ci-dessous en lien avec les figures 1k et 1l) est réalisée par une gravure en phase vapeur à base de difluorure de xénon (XeF₂), car une couche fluoropolymère est typiquement hautement sélective par rapport à cet agent de gravure.

Un dépôt sélectif est généralement plus compliqué à réaliser sur les surfaces verticales des flancs 195 des composants horlogers, et pour cette raison la formation de la couche d'oxyde 155 par oxydation thermique reste privilégiée à l'étape de la figure 1i. Dans ce cas, comme illustré à la figure 1j, une gravure directionnelle, notamment de type DRIE ou ICP-RIE (« Inductively Coupled Plasma - Reactive Ion Etching » en anglais), est effectuée pour graver la couche d'oxyde 150 et la couche d'oxyde 155 qui se trouve au fond des régions 135 de la couche simple jusqu'au point auquel les parties de la couche d'oxyde 155 se trouvant en dessous des régions 135 sont éliminées. Cette gravure directionnelle a lieu dans le sens vertical de la plaquette 110 depuis son côté 110B comme illustré par les flèches dans la figure 1j et agit sur toutes les surfaces perpendiculaires au flux de gravure. Puisque l'épaisseur de la couche d'oxyde 150 est plus importante que l'épaisseur de la couche d'oxyde 155, en contrôlant les paramètres et la durée de la gravure, une couche d'oxyde amincie 150' (avec une plus faible épaisseur que la couche 150 initiale) est toujours présente sur les surfaces supérieures de la couche simple structurée 130' à la fin de cette étape de gravure. La gravure étant directionnelle, la couche d'oxyde 155 sur les surfaces verticales de la couche simple structurée 130' (notamment sur les flancs 195 des composants horlogers) sont peu exposées aux ions réactifs durant la gravure et donc sont peu, voire pas, gravées, la gravure directionnelle agissant surtout sur la couche d'oxyde 150 et les parties de la couche d'oxyde 155 qui sont disposées horizontalement sur la plaquette 110 en dessous des régions 135. Pour cette raison, la présence d'une couche de protection sur les surfaces des flancs 195 n'est pas indispensable durant la gravure directionnelle, même si cela est privilégié.

Une gravure plasma sélective directionnelle utilisant au moins un gaz fluoré (tel que CHF₃, C₄F₈, ou SF₆) en combinaison avec au moins un des gaz He et/ou H₂ peut être employée lors de l'étape de la figure 1j en fonction des sélectivités et des vitesses de gravure voulues. Avantageusement, cette étape de gravure directionnelle de la figure 1j peut être réalisée sans masque d'exposition rendant cette étape relativement rapide et économique. A la fin de cette étape, le silicium de la couche simple structurée 130' est exposé en dessous des régions 135, mais les surfaces des flancs 195 des composants horlogers sont toujours protégés par la couche d'oxyde 155.

Selon une variante, si la couche de protection sur les surfaces des flancs 195 comprend un matériau autre que l'oxyde de silicium (SiO₂) et notamment si on n'a pas de couche d'oxyde de silicium (SiO₂) en dessous des régions 135, la gravure directionnelle de l'étape 1j n'est plus nécessaire. Dans ce cas, on peut procéder directement à l'étape de la figure 1k.

Similairement, selon une variante, si une couche d'oxyde 150 n'a pas été formée sur la surface supérieure de la couche simple avant les étapes de lithographie pour former les composants horlogers, après l'étape de la figure 1h, une couche de protection peut être sélectivement déposée sur les surfaces des flancs 195 et sur la surface supérieure des composants horlogers sans couvrir les régions exposées de la couche simple structurée 130' en dessous des régions 135. Dans ce cas, l'étape de gravure directionnelle de la figure 1j peut aussi être omise, et on peut procéder directement à l'étape de la figure 1k.

A la figure 1k, on commence une étape de gravure du silicium de la couche simple structurée 130' afin d'excaver une portion de cette couche en dessous des composants horlogers 90. Plus particulièrement, la couche simple structurée 130' est gravée où elle est exposée en dessous des régions 135. Selon la variante illustrée, une gravure humide/chimique anisotrope est utilisée à cette étape pour former des régions gravées 122 dans la couche simple structurée 130'. La gravure anisotrope permet d'éliminer le silicium plus rapidement dans certaines directions dans chaque région gravée 122, selon les orientations cristallines de la plaquette. Les surfaces des flancs des régions gravées 122 forment donc un angle et en général cet angle varie en fonction de différents paramètres incluant notamment l'orientation cristalline du silicium. De préférence, un bain d'hydroxyde de potassium (KOH) peut être utilisé pour cette gravure anisotrope, mais alternativement on peut également utiliser par exemple un bain de d'hydroxyde de tétraméthylammonium (TMAH). Selon une autre variante pour l'étape de la figure 1k, on peut utiliser une technique de gravure isotrope pour attaquer le silicium de la couche simple structurée 130', par exemple une gravure en phase vapeur à base de difluorure de xénon (XeF₂). Une telle gravure isotrope élimine le silicium plus ou moins uniformément dans toutes les directions créant ainsi des régions gravées 122 de la couche de support ayant la forme (en section) de demi-cercles en dessous des régions éliminées de la couche d'oxyde enterrée.

De préférence, l'étape de gravure de la figure 1k continue afin que les régions gravées 122 dans lesquelles le silicium de la couche simple structurée 130' a été éliminé s'unissent pour former une cavité 124 s'étendant en dessous de chaque composant horloger 90 comme illustré dans la figure 1l afin de libérer les composant horlogers. On obtient donc une couche simple structurée et excavée 130" comprenant ces cavités 124 en dessous des composants horlogers 90. Si la gravure (anisotrope ou isotrope) de la couche de support n'est pas strictement contrôlée, les cavités 124 n'ont typiquement pas une épaisseur uniforme, mais de préférence l'épaisseur maximale de chaque cavité e_{cav} est au plus égale à 30% de l'épaisseur e₁₃₀ de la couche simple 130, et il est encore plus préféré que l'épaisseur maximale e_{cav} de chaque cavité 124 est au plus égale à 20% de l'épaisseur e₁₃₀ de la couche simple. Cependant, l'épaisseur maximale de chaque cavité e_{cav} peut également être plus importante, et il est même possible que la cavité 24 soit traversante en dessous des composants afin que e_{cav} + e₉₀ est égale à e₁₃₀.

Selon le mode de réalisation privilégié dans lequel la réalisation de la couche d'oxyde 155 durant l'étape de la figure 1i est par une oxydation thermique, la gravure du silicium aux étapes des figures 1k et 1l attaque la couche simple structurée 130' uniquement au travers le fond des régions éliminées 135 de cette couche, les autres surfaces de la couche simple structurée 130' étant protégées par la couche d'oxyde 155.

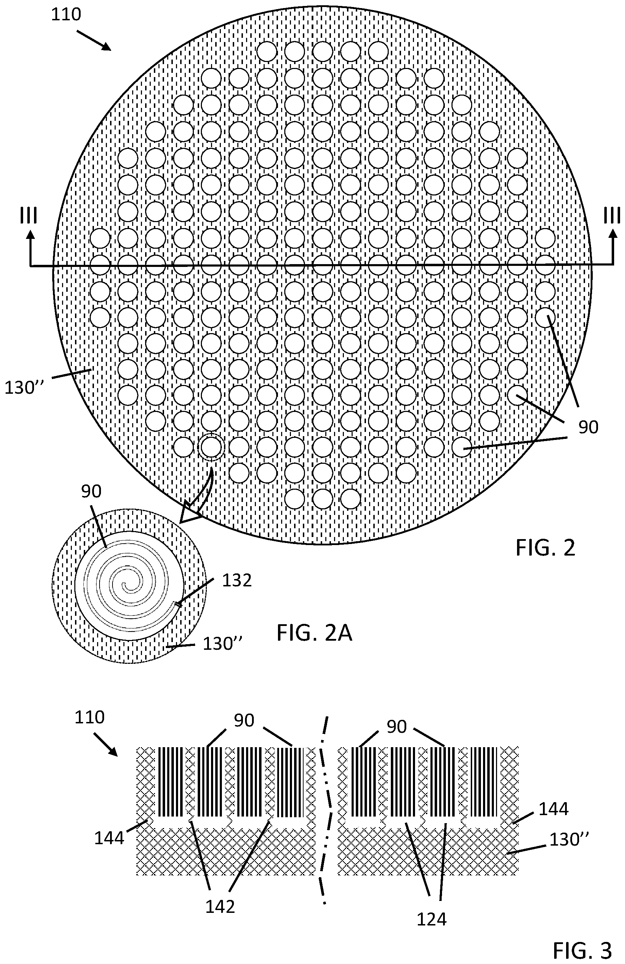

Finalement, on effectue à la figure 1m une étape de désoxydation, ce qui élimine les couches d'oxyde 150' et 155. Cette étape de désoxydation peut être réalisée, par exemple, par une gravure par voie humide ou en phase vapeur ou gaz, par exemple à base d'acide fluorhydrique (HF) ou de gaz HF anhydre. On obtient donc une plaquette consistant en la couche simple structurée et excavée 130" qui comprend des parties 142, 144 (voir la figure 3) où le matériau de la couche simple est toujours intact sur toute l'épaisseur e₁₃₀ de la couche gardant alors cette couche suffisamment rigide et permettant la partie inférieure et non excavée de la couche simple structurée et excavée 130" vers le côté 110A de la plaquette d'agir comme support durant des étapes de fabrication subséquentes.

Si la couche de protection sur les flancs 195 comprend un matériau autre que l'oxyde de silicium (SiO₂), cette couche de protection pourrait être enlevée ou éliminée avant ou après l'étape de la figure 1m par une technique appropriée. Par exemple, dans le cadre d'une résine ou d'une couche de fluoropolymère, on peut utiliser un plasma dioxygène (O₂) pour enlever une telle couche de protection.

Les composants horlogers 90 sont alors libérés sur la plaquette simple 110 (consistant en la couche simple structurée et excavée 130'') permettant la réalisation des étapes de fabrication subséquentes, comme le sera décrit ci-dessous, sur la quasi-totalité de la surface externe de ces composants. A cette fin, après la libération, les composants horlogers 90 ne sont supportés structurellement que par des ponts de liaison (illustrés schématiquement par le trait 132 dans la figure 1m; en réalité le pont s'étend sur toute l'épaisseur du composant) dans la couche simple structurée et excavée 130". De cette manière, les composants 90 restent attachés aux parties subsistantes de la couche simple structurée et excavée 130". Cela est illustré dans la figure 2 qui est une vue de dessus de la plaquette simple 110 et notamment de la couche simple structurée et excavée 130" après les étapes de fabrication des figures 1a-1m selon un mode de réalisation. A noter que dans la figure 2 les composants horlogers 90 se trouvent dans des zones de la couche qui sont simplement illustrés par des cercles vides afin de ne pas surcharger le dessin, mais la figure 2A donne une vue magnifiée d'une de ces zones montrant à titre d'exemple un spiral comme le composant horloger et son pont de liaison 132. La figure 3 est également une vue en section selon la ligne VI-VI de la figure 2 montrant une cavité 124 libérant chacun des composants horlogers 90 par le dessous. Malgré cette libération, la couche simple structurée et excavée 130" a une structure relativement robuste pour la réalisation des étapes de fabrication subséquentes au vu de la profondeur limitée des cavités 124 et de la présence des parties 142, 144 qui sont intactes sur toute l'épaisseur e₁₃₀ de la couche simple. Comme illustré aux figures 2 et 3, les parties 144 situées à la périphérie de la plaquette 110 ont de préférence une largeur plus importante que les parties 142 se trouvant entre les composants horlogers 90.

Dans le mode de réalisation décrit ci-dessus, chaque composant horloger 90 de la plaquette a sa propre cavité 124, voire une cavité 124 dédiée à ce composant qui s'étend uniquement en dessous de ce composant. Selon un autre mode de réalisation, une seule cavité 124 peut s'étendre en dessous de plusieurs composants de la plaquette. On peut même avoir une seule cavité 124 qui s'étend en dessous de tous les composants de la plaquette 110, et dans ce cas c'est uniquement des parties périphériques 144 qui sont intactes sur toute l'épaisseur de la couche simple structurée et excavée 130".

Après l'étape de gravure de la couche de travail pour former les composants horlogers 90 (cf. la figure 1h), il est connu que les surfaces des flancs 195 des motifs structurés des composants 90 possèdent une rugosité relativement importante. Dans le cadre d'une gravure de type DRIE, cette rugosité se manifeste en forme d'une surface 195' avec des ondulations souvent appelées « scallops » avec des pics 196 comme illustré à la partie gauche de la figure 1h. En fait, lors d'une gravure DRIE on alterne entre une phase de gravure du silicium et une phase de passivation ce qui résulte en la surface ondulée 195'. Après une gravure DRIE ou un autre type de gravure, la rugosité des surfaces des flancs 195 peut être réduite par une étape de lissage, ce qui renforce ces surfaces mécaniquement en limitant les amorces de rupture. Ce lissage peut notamment être effectué par une étape d'oxydation thermique suivie par une étape de désoxydation, constituée par exemple d'une gravure par voie humide ou en phase vapeur, par exemple à base d'acide fluorhydrique (HF) ou de gaz HF anhydre. De manière connue, lors de l'oxydation thermique, le silicium à la surface des flancs 195 est consommée, et cette consommation est généralement plus rapide vers les pics 196, ce qui résulte en une surface de silicium plus lisse après la désoxydation. Si à l'étape de la figure 1i on forme la couche d'oxyde 155 sur les surfaces flancs 195 du composant 90 par oxydation thermique, cela permet de réaliser un lissage des flancs des composants horlogers durant l'étape de désoxydation à la figure 1m.

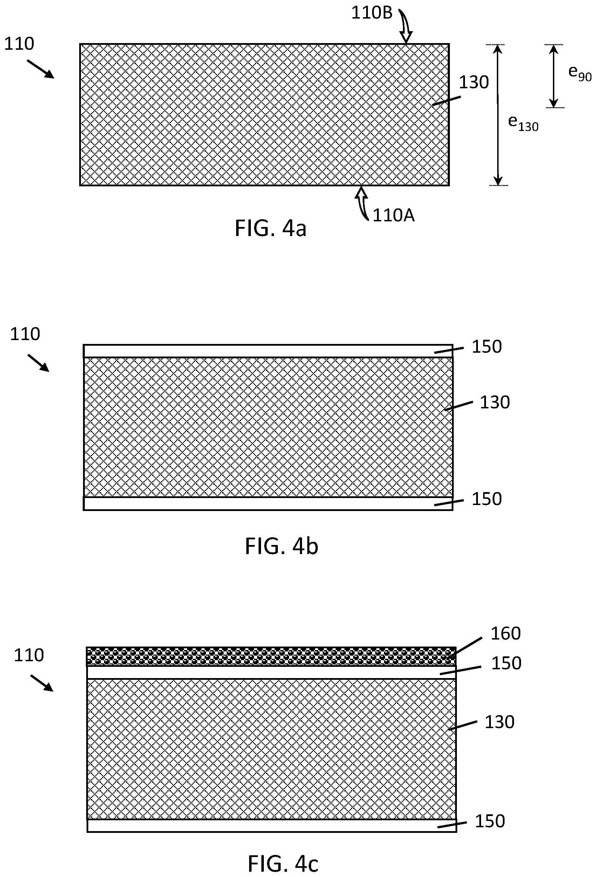

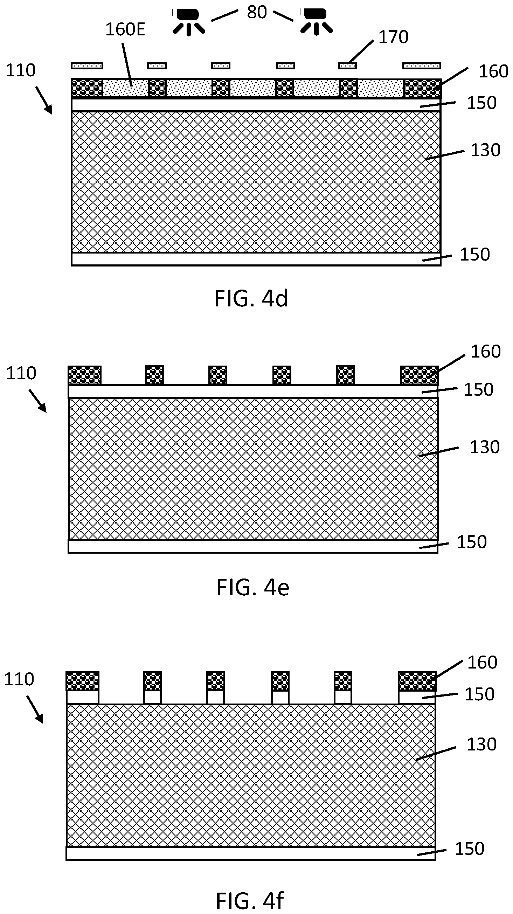

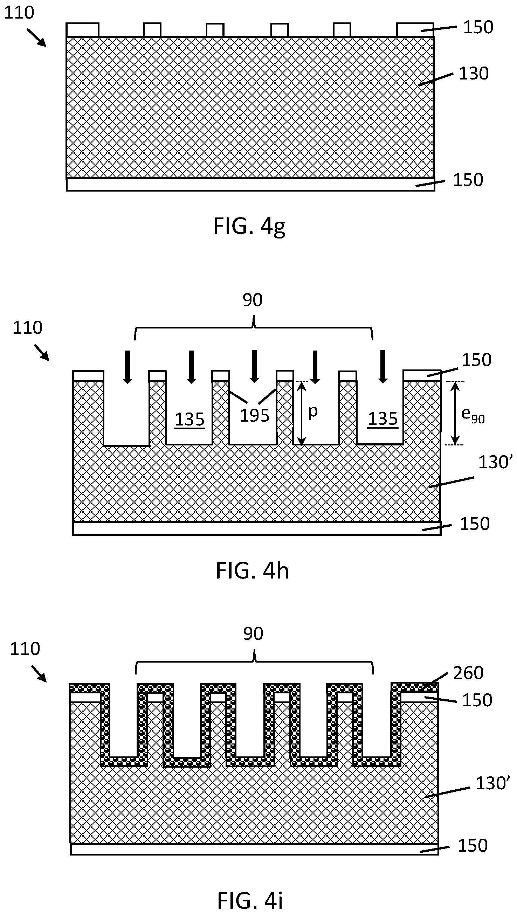

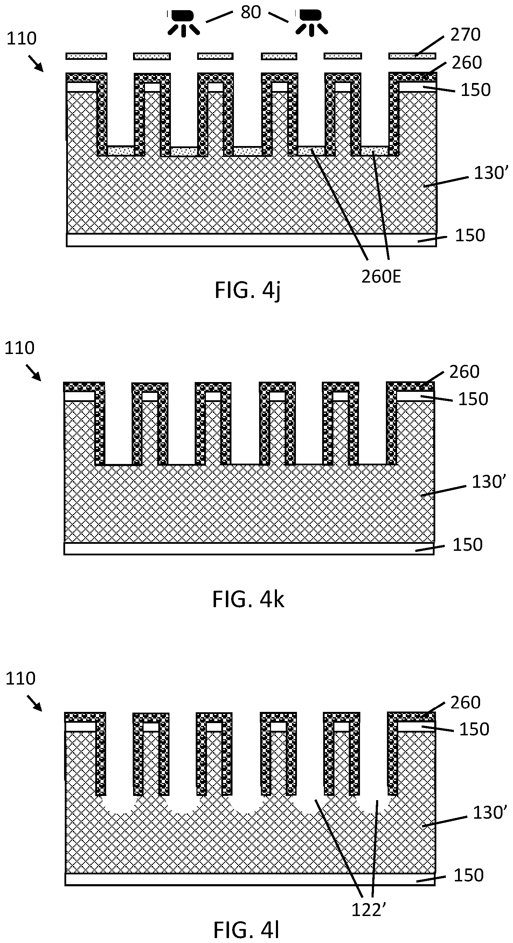

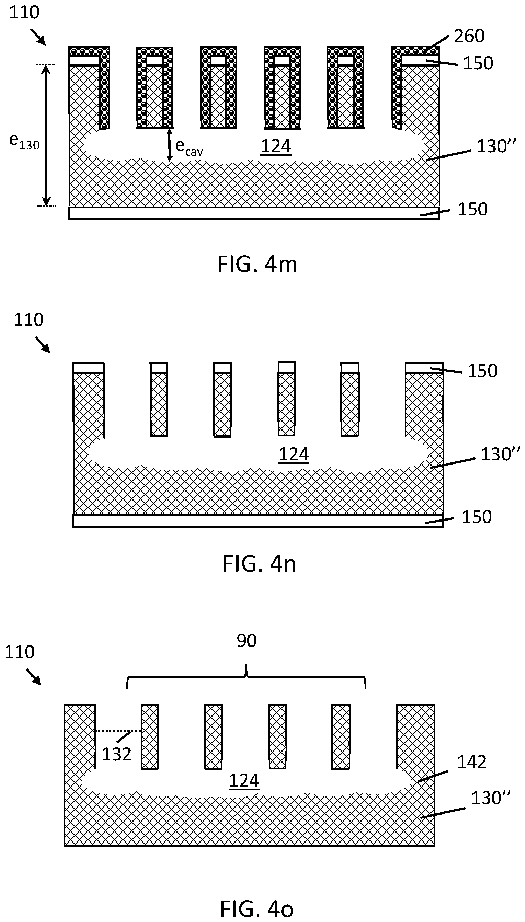

Les figures 4a-4o illustrent une série d'étapes de fabrication schématiques d'un composant horloger dans la plaquette simple 110 selon un autre mode de réalisation de l'invention. Comme pour le mode de réalisation de la figure 1, plusieurs composants horlogers peuvent être fabriqués dans la plaquette 110 en même temps, mais les vues de la figure 4 sont isolées sur un seul composant pour des raisons de simplicité.

Les étapes des figures 4a-4h pour former les composants horlogers 90 correspondent aux étapes des figures 1a-1h à l'exception qu'a la figure 4b la couche d'oxyde 150 est formée également (par exemple, par oxydation thermique) sur la surface inferieure de la couche simple en silicium 130. Pour le reste, la description ci-dessus en association avec les figures 1a-1h s'applique et ne sera pas répétée ici.

A la figure 4i, la couche simple structurée 130' est recouverte depuis son côté supérieur 110B par un matériau de masque, qui est de préférence une couche de résine 260 mais peut alternativement comprendre un autre matériau au moins hautement sélectif pour l'agent de gravure tel qu'un métal (par exemple, aluminium, nickel, chrome, ou platine), un oxyde (SiO2, MgO, ZnO, TiO2, ZrO2, ou Al2O3), un nitrure (AIN ou Si3N4), ou tout autre polymère ou matériau organique de haute sélectivité (tel que le C₄F₈, le PDMS, ou l'acrylique). Le matériau de masque couvre alors les surfaces des flancs 195 des composants horlogers, la couche d'oxyde 150 sur la surface supérieure des composants horlogers et le fond des régions éliminées 135 de la couche simple structurée 130'. A cet égard, le masque sert à protéger les composants horlogers 90 lors des étapes de fabrication suivantes de ce mode de réalisation. Selon une variante, on peut également déposer une couche d'oxyde de silicium en premier (à l'instar de la couche oxyde 155 du mode de réalisation de la figure 1) et par la suite le matériau de masque.

Selon le mode de réalisation illustré, la résine 260 est de préférence une résine photosensible de type positif, et elle peut avoir une épaisseur allant jusqu'à 6µm, à titre illustratif. Le dépôt de la résine 260 est de préférence effectué par un revêtement de pulvérisation (en anglais « spray coating ») mais il peut également être réalisé par un trempage (an anglais « dip coating »), par une enduction centrifuge (en anglais « spin coating »), ou par un dépôt sous vide avec de la poudre.

Par la suite, dans la figure 4j, la couche de résine 260 est structurée, de préférence en utilisant une étape de photolithographie avec une source de lumière ultraviolette 80 ainsi que, par exemple, un masque d'exposition 270 tel qu'un photomasque. Un système de stepper et réticule peut également être utilisé pour l'étape de photolithographie ou encore un système d'écriture direct. Dans l'exemple illustré, la couche 260 comprend une résine photosensible de type positif dont les parties 260E de la résine qui sont exposées à la lumière deviennent solubles dans un révélateur et les parties non exposées restent insolubles. Selon d'autres modes de réalisation, la résine peut être structurée par un faisceau laser ou d'électrons.

Comme illustré dans la figure 4j, les parties exposées 260E de la résine 260 se trouvent au fond des régions éliminées 135 de la couche simple structurée 130' entre les structures (ou motifs) du composant horloger 90. Selon une variante (non illustrée), les parties exposées 260E de la résine 260 peuvent être plus étroites et situées uniquement vers le milieu des régions éliminées 135 ne s'étendant pas vers les bords de ces régions près des surfaces des flancs 195 des composants horlogers 90 afin d'éviter le retrait de la résine sur ces surfaces des flancs. Cependant, si la couche de résine 260 est relativement épaisse, cela n'est pas nécessaire.

Dans la figure 4k, la couche de résine 260 est ouverte (voire elle est structurée) après avoir été développée par un révélateur, notamment un solvant qui élimine, par voie chimique, les parties exposées 260E de la résine au fond des régions éliminées 135 de la couche simple structurée 130'. Si une couche d'oxyde de silicium a été formée en dessous de la couche de résine 260 en premier, les parties de cette couche d'oxyde se trouvant en dessous des parties exposées 260E de la résine seraient aussi retirées par la suite (par exemple en employant une gravure humide ou à base de vapeur d'acide hydrofluorique (HF) ou une gravure plasma sélective).

A la figure 4l, on commence une étape de gravure du silicium de la couche simple structurée 130' afin d'excaver une portion de cette couche en dessous des composants horlogers 90. Comme dans le mode de réalisation de la figure 1, la couche simple structurée 130' est gravée où elle est exposée en dessous des régions 135. Selon la variante illustrée, une technique de gravure isotrope est utilisée pour attaquer le silicium de la couche simple structurée 130', par exemple une gravure vapeur à base de difluorure de xénon (XeF₂), et former des régions gravées 122' dans la couche simple structurée 130'. Selon une variante, une gravure humide/chimique anisotrope est utilisée à cette étape, par exemple avec un bain d'hydroxyde de potassium (KOH).

De préférence, l'étape de gravure de la figure 4l continue afin que les régions gravées 122' dans lesquelles le silicium de la couche simple structurée 130' a été éliminé s'unissent pour former une cavité 124 s'étendant en dessous de chaque composant horloger 90 pour les libérer comme illustré dans la figure 4m. Comme dans le mode de réalisation de la figure 1, on obtient donc une couche simple structurée et excavée 130" comprenant ces cavités 124 en dessous des composants horlogers 90. Encore, l'épaisseur maximale e_{cav} de chaque cavité 124 peut être au plus égale à 30% de l'épaisseur e₁₃₀ de la couche simple 130 et de préférence au plus égale à 20% de cette épaisseur. Cependant, l'épaisseur maximale de chaque cavité e_{cav} peut également être plus importante, et il est même possible que la cavité 24 soit traversante en dessous des composants afin que e_{cav} + e₉₀ est égale à e₁₃₀.

Puisque la couche d'oxyde 150 a été formée également sur les surfaces en silicium exposées de la couche simple à l'étape 4b, la gravure des étapes 4l et 4m attaque cette couche uniquement au travers le fond des régions 135, les autres surfaces de la couche de simple structurée 130' étant protégées par la couche d'oxyde 150 et la résine 260.

A l'étape illustrée à la figure 4n, la partie restante de la couche de résine 260 est éliminée. Finalement, pour compléter ce mode de réalisation, on effectue à la figure 4o une étape de désoxydation, ce qui élimine la couche d'oxyde 150 restant sur la plaquette. Optionnellement, une étape d'oxydation thermique peut être réalisée avant cette étape de désoxydation afin que la désoxydation effectue également un lissage des surfaces des composants horloger comme décrit ci-dessus. Cette étape de désoxydation peut être réalisée, par exemple, par une gravure par voie humide ou en phase vapeur, par exemple à base d'acide fluorhydrique (HF) ou de gaz HF anhydre. On obtient donc une plaquette consistant en la couche simple structurée et excavée 130" qui comprend des parties 142, 144 (comme dans la figure 3) où le matériau de la couche simple est toujours intact sur toute l'épaisseur e₁₃₀ de la couche gardant alors cette couche suffisamment rigide et permettant la partie inférieure et non excavée de la couche simple structurée et excavée 130" d'agir comme support durant des étapes de fabrication subséquentes.

Après la libération des composants horlogers 90 selon l'un des modes de réalisation décrits ci-dessus, une autre étape d'oxydation thermique suivie par une étape de désoxydation peut être réalisée pour effectuer un lissage au moins une nouvelle fois, si souhaité. Les étapes de libération des composants horlogers décrites ci-dessus peuvent éventuellement graver les composants par leur dessous légèrement, mais l'effet d'une telle gravure peut être limité par une telle étape de lissage subséquente.

D'autres étapes de fabrication subséquentes au lissage et à la libération peuvent aussi être effectuées. Par exemple, on peut effectuer une autre étape d'oxydation suivie par une désoxydation pour ajuster les dimensions des composants, ou on peut former une couche d'oxyde de silicium (SiO₂) permanente sur au moins une partie de la surface externe des composants horlogers 90. Dans le cadre d'un spiral ou d'un autre type de résonateur horloger, une telle couche d'oxyde permanente compense les variations du module d'Young de l'âme du spiral en silicium du composant horloger en fonction de la température. Par ailleurs, la formation d'une telle couche externe d'oxyde de silicium sur les composants horlogers de n'importe quel type peut également servir à renforcer ces composants mécaniquement. D'autres types de matériaux peuvent également être formés sur les composants horlogers 90, par exemple par un dépôt type ALD. Il est également possible d'effectuer une étape de pré-assemblage ou d'usinage des composants horlogers 90 lorsqu'ils sont toujours attachées à la plaquette 110, comme par exemple pour assembler le composant à un axe, un tigeron, un piton ou une virole.

Les différentes étapes d'oxydation mentionnées ci-dessus peuvent être réalisées en plaçant la plaquette 110 dans un four à une température comprise entre 800°C et 1200°C et dans une atmosphère oxydante comprenant par exemple la vapeur d'eau ou du gaz de dioxygène (O₂). L'épaisseur de la couche d'oxyde formée dépend de manière connue de la durée de l'étape d'oxydation.

Une fois que les étapes de fabrication des composants horlogers 90 sur la plaquette 110 sont complétées, les composants horlogers peuvent être détachées individuellement (notamment en cassant les ponts 132) et par la suite assemblé et monté chacun dans une pièce d'horlogerie, par exemple dans un oscillateur ou dans un mécanisme d'échappement d'un mouvement horloger mécanique.

La présente invention n'est pas limitée aux modes de réalisation et variantes présentés et d'autres modes de réalisation et variantes apparaîtront clairement à l'homme du métier. Ainsi, les réalisations ci-dessus sont des exemples. Bien que la description se réfère à un ou plusieurs modes de réalisation et leurs variantes, ceci ne signifie pas nécessairement que chaque référence concerne le même mode de réalisation ou variante, ou que les caractéristiques s'appliquent seulement à un seul mode de réalisation ou variante. De simples caractéristiques de différents modes de réalisation et leurs variantes peuvent également être combinées et/ou interchangées pour fournir d'autres réalisations.

## Revendications

1. Procédé de fabrication dans une plaquette d'une pluralité de composants horlogers (90) présentant des flancs (195) ayant des surfaces, le procédé comprenant les étapes suivantes :
(a) se doter d'une plaquette (110) ayant un côté inférieur (110A) et un côté supérieur (110B), la plaquette (110) comprenant une couche simple en silicium (130) sans couche de support, la couche simple (130) ayant une épaisseur (e₁₃₀) plus importante qu'une épaisseur maximale (e₉₀) des composants horlogers ;
(b) former les composants horlogers (90) en gravant des motifs dans la couche simple en silicium (130) depuis le côté supérieur (110B) de la plaquette (110) afin d'obtenir une couche simple structurée (130'), la couche simple structurée (130') comprenant des régions éliminées (135) autour des motifs gravés dans lesquelles le matériau de la couche simple a été éliminé, et les régions éliminées (135) ayant une profondeur (p) correspondant sensiblement à l'épaisseur maximale (e₉₀) des composants horlogers ;
(c) former une couche de protection (155, 260) au moins sur les surfaces des flancs des composants horlogers gravés à l'étape (b); et
(d) effectuer une gravure du silicium dans la couche simple structurée (130') à travers les régions éliminées (135) de ladite couche afin d'obtenir une couche simple structurée et excavée (130") ayant au moins une cavité (124) formée en dessous d'au moins un composant horloger (90).

2. Procédé selon la revendication précédente comprenant également une étape consistant à former une couche en oxyde de silicium structurée (150) sur la surface supérieure de la couche simple (130), la gravure des motifs dans la couche simple en silicium (130) à l'étape (b) étant effectuée au travers de la couche en oxyde de silicium structurée (150).

3. Procédé selon la revendication précédente, dans lequel la formation de la couche de protection à l'étape (c) est réalisée par oxydation thermique, la couche de protection (155) étant en oxyde de silicium et se formant également sur des surfaces en silicium exposées de la couche simple structurée (130'), incluant au moins une surface au fond des régions éliminées (135) de ladite couche, la couche de protection (155) ayant une épaisseur inférieure à l'épaisseur de la couche en oxyde de silicium structurée (150) sur la surface supérieure de la couche simple.

4. Procédé selon la revendication précédente comprenant également, entre les étapes (c) et (d), une étape consistant à effectuer une gravure de la couche en oxyde de silicium structurée (150) sur la surface supérieure de la couche simple et de la couche de protection (155) au fond des régions éliminées (135) de la couche simple structurée (130') jusqu'au point auquel la couche de protection (155) au fond des régions éliminées (135) est éliminée, une couche d'oxyde structurée amincie (150') étant toujours présente sur la surface supérieure de la couche simple structurée (130') après cette étape.

5. Procédé selon la revendication précédente, dans lequel la gravure entre les étapes (c) et (d) est directionnelle de type DRIE ou ICP-RIE et utilise de préférence au moins un gaz fluoré tel que CHF₃, C₄F₈, ou SF₆ en combinaison avec au moins un des gaz He et/ou H₂.

6. Procédé selon l'une des revendications 4 ou 5 comprenant également, après l'étape (d), une étape consistant à éliminer les parties restantes de la couche en oxyde de silicium structurée amincie (150') et de la couche de protection (155).

7. Procédé selon l'une des revendications 1 ou 2, dans lequel durant la formation de la couche de protection à l'étape (c), un matériau de masque (260) est formé sur au moins les surfaces des flancs (195) des composants horlogers et le fond des régions éliminées (135) de la couche simple structurée (130').

8. Procédé selon la revendication précédente, comprenant également l'étape consistant à structurer le matériau de masque (260) en éliminant au moins une partie du matériau de masque formé au fond des régions éliminées (135) de la couche simple structurée (130'), la gravure du silicium dans la couche simple structurée (130') à l'étape (d) étant effectuée à travers les parties éliminées du matériau de masque.

9. Procédé selon l'une des revendications 7 ou 8, dans lequel le matériau de masque (260) comprend une résine, un métal, un oxyde, un nitrure, ou un polymère.

10. Procédé selon l'une des revendications précédentes, dans lequel la gravure du silicium dans la couche simple structurée (130') à l'étape (d) comprend une gravure anisotrope.

11. Procédé selon la revendication précédente, dans lequel la gravure anisotrope à l'étape (d) utilise un bain d'hydroxyde de potassium (KOH) ou un bain de d'hydroxyde de tétraméthylammonium (TMAH).

12. Procédé selon l'une des revendications 1 à 9, dans lequel la gravure du silicium dans la couche simple structurée (130') à l'étape (d) comprend une gravure isotrope.

13. Procédé selon la revendication précédente, dans lequel la gravure isotrope à l'étape (d) est à base de difluorure de xénon (XeF₂).

14. Procédé selon l'une des revendications précédentes, dans lequel chaque composant horloger (90) de la plaquette (110) a sa propre cavité (24) qui s'étend uniquement en dessous de ce composant horloger (90).

15. Procédé selon l'une des revendications précédentes, le procédé comprenant, après l'étape (d), une étape d'oxydation thermique suivie par une étape de désoxydation pour effectuer un lissage des composants horlogers (90) ou pour ajuster les dimensions des composants horlogers et/ou une étape consistant à former une couche d'oxyde de silicium permanente sur au moins une partie de la surface externe des composants horlogers (90), et dans lequel la couche simple structurée et excavée (130") comprend une partie inférieure vers le côté 110A de la plaquette qui n'est pas excavée et agit comme support durant ces étapes subséquentes à l'étape (d).

16. Procédé selon l'une des revendications précédentes, dans lequel une épaisseur maximale de chaque cavité (e_{cav}) est au plus égale à 30% de l'épaisseur (e₁₃₀) de la couche simple (130), et de préférence au plus égale à 20% de l'épaisseur (e₁₃₀) de la couche simple (130).

17. Procédé selon la revendication précédente, dans lequel la formation des composants horlogers (90) à l'étape (b) est réalisée par une technique de gravure de type DRIE.

18. Procédé selon la revendication précédente, dans lequel lors de la gravure de type DRIE réalisée à l'étape (b) une couche de fluoropolymère se forme sur les surfaces des flancs (195) des composants horlogers gravés, et la couche de protection de l'étape (c) comprend cette couche de fluoropolymère.
